# EUROPÄISCHE PATENTANMELDUNG

(11) **EP 3 525 558 A1**
(43) Veröffentlichungstag der Anmeldung: **14.08.2019**
(21) Anmeldenummer: 18156325.5
(22) Anmeldetag: 12.02.2018
(51) Int. Cl.: H05K 1/02, H05K 3/46

(54) **LEITERPLATTE**

(71) Anmelder: IQ evolution GmbH, 52074 Aachen (DE)
(72) Erfinder: Ebert, Thomas, 52146 Würselen (DE)
(74) Vertreter: Paul & Albrecht Patentanwälte PartG mbB

(57) **Zusammenfassung**

Leiterplatte, insbesondere eine Hochfrequenzplatine (1), die einen Kühlabschnitt (4) mit mindestens einem Mikrokühlkörper (6) aufweist, über den sich an der Hochfrequenzplatine (1) entwickelnde Wärme abführbar ist, wobei der Kühlabschnitt (4) so ausgebildet ist, dass der Mikrokühlkörper (6) in Bereichen großer Wärmeentwicklung, insbesondere unmittelbar unterhalb von an der Hochfrequenzplatine (1) angebrachten aktiven Schaltungen, angeordnet ist, und in Bereichen geringer Wärmeentwicklung ein Material mit geringerer Wärmeleitfähigkeit aufweist.

## Beschreibung

Die vorliegende Erfindung betrifft eine Leiterplatte, insbesondere eine Hochfrequenzplatine (HF-Platine), die einen Kühlabschnitt mit mindestens einem Mikrokühlkörper aufweist, über den an der Leiterplatte sich entwickelnde Wärme abführbar ist.

Im Stand der Technik ist bekannt, Platinen für elektronische Geräte herzustellen. Auf diesen Platinen werden Bauteile wie beispielsweise aktive Schaltungen befestigt. Gerade im Bereich von aktiven Schaltungen wie beispielsweise Hochfrequenzverstärkern ist es unumgänglich, dass sich in deren Betrieb eine große Wärmeentwicklung einstellt.

Dazu ist im Stand der Technik vorgesehen, dieser großen Wärmeentwicklung entgegenzutreten, indem zwischen einer Oberseite der Platine und einer Unterseite der Platine ein Kupferkern zur Wärmeabfuhr zwischengeschaltet wird. Dieser wird in Form einer Kupferplatte ausgebildet. Die Wärmeabfuhr erfolgt dementsprechend über die gesamte Kupferplatte, was einer Wärmespreizung gleichzusetzen ist.

Ein solcher Aufbau hat mehrere Nachteile. Zum einen erfolgt die Wärmespreizung über die gesamte Fläche der Kupferplatte und dementsprechend auch an Ober- und Unterseite in Bereichen der Platine, in denen wärmeempfindlichere Bauteile angeordnet sein können. Dies kann zu deutlichen Einbußen der Funktionalität dieser wärmeempfindlicheren Bauteile führen. Aufgrund der Vollflächigkeit der Kupferplatte ist die Leiterplatte schwer. Auch eine Durchkontaktierung der Platine ist durch den vollflächigen Kupferkern erschwert.

Des weiteren wird im Stand der Technik angestrebt, die Packungsdichte auf der Platine deutlich zu erhöhen und die Abmessungen der Platine dabei deutlich zu verkleinern. Dazu werden die auf die Platine anzubringenden Bauteile auf der Platine verklebt.

Sollen nun Bauteile von der Oberseite der Platine mit Bauteilen von der Unterseite der Platine gekoppelt werden, ist es notwendig, in diesen Bereichen sogenannte Vias vorzusehen. Das Vorsehen dieser Vias gerade bei Multilayer-Platinen verkürzt zum einen die Wege zwischen den Kontaktierungen deutlich und macht eine sehr aufwendige Verdrahtung an der Platine obsolet.

Es ist daher Aufgabe der vorliegenden Erfindung, eine Leiterplatte, insbesondere eine Hochfrequenzplatine bereitzustellen, welche unter Verringerung der Abmessungen leichter und kostengünstiger zu fertigen ist.

Diese Aufgabe wird erfindungsgemäß dadurch gelöst, dass ein Kühlabschnitt in der Platine vorgesehen ist, der Abschnitte mit großer Wärmeleitfähigkeit aufweist, sowie Abschnitte mit geringfügiger Wärmeleitfähigkeit, wobei die Abschnitte mit großer Wärmeleitfähigkeit durch mindestens einen Mikrokühlkörper gebildet ist und die mit geringfügig wärmeleitenden Abschnitte sich über Bereiche der Platine erstrecken, in denen keine oder sehr geringfügige Wärmeentwicklung in der Platine herrscht, durch ein thermisch nur geringfügig leitendes Material gebildet ist.

Mit anderen Worten wird erfindungsgemäß vorgeschlagen, einen integrierten Mikrokühlkörper mit aktiver Kühlung bereitzustellen, der im wesentlichen direkt unterhalb der auf der Oberseite der Leiterplatte vorgesehenen Wärme generierenden Bauteile angeordnet ist, nämlich in den Bereichen großer Wärmeentwicklung unmittelbar im Bereich der an der Platine angeordneten aktiven Schaltungen.

In den Bereichen, in denen keine großen Wärmespitzen zu erwarten sind, werden Abschnitte aus einem geringfügig leitenden Material eingesetzt. So ist es möglich, eine Modulare Kühlung der Platine zu generieren.

Außerhalb der Bereiche großer Wärmeentwicklung ist eine Durchkontaktierung durch die Hochfrequenzplatine wesentlich einfacher zu realisieren, nämlich indem das Material, welches keine oder eine geringfügige Wärmeleitfähigkeit besitzt, gerade nicht leitfähig auszugestalten.

Außerdem ist es durch die effektive Kühlung mittels des eingebrachten Kühlkörpers nun möglich, wärmeentwickelnde elektronische Bauteile mit weniger Abstand zu einander auf der Platine zu platzieren, zum Beispiel um höhere Frequenzen zu erreichen.

Neben des wesentlich einfacheren und leichteren Aufbaus der erfindungsgemäßen Leiterplatte, insbesondere der HF-Platine kommt es aufgrund der verschiedenartigen Materialien im Bereich zwischen der Oberseite und der Unterseite der HF-Platine zu einer deutlichen Gewichtsreduktion, da nur die Bereiche, in denen die Wärme aktiv abgeführt werden soll, aus Kupfer oder Nickel gefertigt sein müssen, das Material mit geringerer Wärmeleitfähigkeit kann beispielsweise ein HF-Material wie keramik- oder PTFE- gefüllter Kunststoff, oder glasfaserverstärkter Kunststoff auf Epoxybasis (z.B. FR4) sein.

Werden mehrere Kühlkörper an einer solchen HF-Platine vorgesehen, so ist es möglich, die aktiven Schaltungen, insbesondere die HF-Verstärker, einer gezielten Temperierung zu unterziehen, da durch die Kühlkörper ein Kühlmedium fließt, dessen Temperatur einstellbar ist und so eine aktive Kühlung mittels des Mikrokühlkörpers bereitgestellt werden kann.

So ist es möglich, mehrere Kühlkörper in dem Halbleiterbauelement vorzusehen, von denen einer mit einem Kühlmedium durchflossen wird, das eine Temperatur von 20°C hat und mindestens einen weiteren Kühlkörper, der weitere aktive Schaltungen kühlt und mit einem Kühlmedium durchströmt wird, das eine Temperatur von beispielsweise eine Temperatur von 25°C aufweist.

Ein weiterer großer Vorteil der mehrteiligen Ausbildung des Kühlbereichs in dem Halbleiterbauelement ist neben der flexibleren Anbringung der Bauteile an der Ober- bzw. Unterseite des Halbleiterbauelements die Möglichkeit, aufgrund der Zuführung des Kühlmediums durch die Kühlkörper eine Temperaturregelung zu generieren. So kann es durchaus sein, dass einer der Kühlkörper innerhalb der Kühlstruktur mit einem Kühlmedium bestückt wird, welches konstant 18°C führt, wobei ein weiterer Kühlkörper in Anlehnung an die Wärmeentwicklung geregelt werden kann, beispielsweise durch eine entsprechende Temperaturmessung und in Abhängigkeit von der gemessenen Temperatur eine Zuführung des Kühlmediums in Bereichen zwischen 10 °C und 28°C. Natürlich können auch mehrere Kühlkörper innerhalb einer Leiterplatte bedarfsgerecht regelbar ausgebildet sein.

Der Mikrokühlkörper kann vorzugsweise aus einem Material wie Nickel, Kupfer bzw. Kupferlegierungen oder Aluminium gefertigt sein. Als Material kann auch Zinn oder Weißbronze gewählt werden.

Das Material mit geringerer Wärmeleitfähigkeit kann aus keramik-gefülltem Kunststoff, PTFE oder glasfaserverstärktem Kunststoff auf Epoxybasis gebildet sein.

Eine besonders einfache Herstellung des Mikrokühlkörpers wird erreicht, indem die Abschnitte mit großer Wärmeleitfähigkeit eine monolithische Struktur aufweisen. Dies kann beispielsweise mittels des selektiven Lasersinterns erreicht werden.

Ein weiterer wesentlicher Vorteil ist die Möglichkeit einer direkten Durchkontaktierungen zwischen den zu kühlenden aktiven Schaltungen und der Leiterplattenrückseite. Die aktive Kühlung des monolithisch ausgebildeten Kühlkörpers wird durch eine Herstellung mittels des selektiven Lasersinterns erreicht. Andere Herstellungsverfahren sind ebenfalls denkbar.

Es kann sich anbieten, mindestens eine Außenfläche des Mikrokühlkörpers eben auszubilden, so dass die aktive Schaltung plan auf die Außenfläche des Mikrokühlkörpers direkt und unmittelbar aufgesetzt oder aufsetzbar ist. Hier bietet es sich an, eine Ausnehmung in eine Ober-und/oder Unterseite der Platine vorzusehen, um die aktive Schaltung direkt mit dem Mikrokühlkörper verkleben oder verlöten zu können.

Durch ein Einbetten des Kühlkörpers in die Platine, wird es möglich, die Leiterplatte sehr kompakt auszubilden.

Es kann zweckmäßig sein, ein Elektronikbauteil vorzusehen, welches mit mindestens einer erfindungsgemäßen Leiterplatte, insbesondere einer Multilayerleiterplatte ausgestattet ist.

Weitere vorteilhafte Ausgestaltung der Erfindung sind den Unteransprüchen sowie der Figurenbeschreibung zu entnehmen.

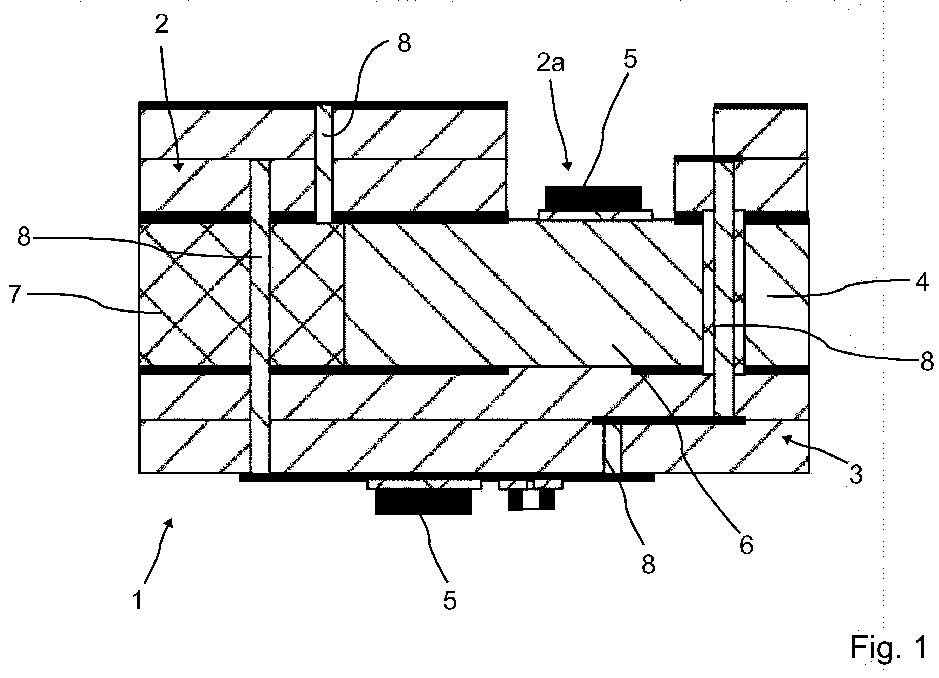

Darin zeigt
- Figur 1: eine Teildarstellung einer Multilayerleiterplatte in der Form einer Hochfrequenzplatine im Schnitt.

Die in Figur 1 gezeigte Hochfrequenzplatine 1 ist eine Multilayerplatine mit einer Oberseite 2 und einer Unterseite 3, die mit einem zwischengeschalteten Kühlabschnitt 4 verklebt sind. Sowohl auf der Oberseite 2 als auch auf der Unterseite 3 ist es möglich, verschiedenartige Schaltungen und elektronische Bauelemente zu befestigen.

In der Figur ist eine aktive Schaltung in Form eines Hochfrequenzverstärkers 5 (HF-Verstärker) gezeigt. Um eine möglichst direkte Kühlung des Hochfrequenzverstärkers 5 zu ermöglichen, ist in der Oberseite 2 der Platine 1 eine Ausnehmung 2a vorgesehen, in die der HF-Verstärker 5 eingesetzt und direkt mit einem in dem Kühlabschnitt vorgesehenen Mikrokühlkörper 6 fest verbunden ist.

Der Mikrokühlkörper 6 ist somit in der HF-Platine 1 unmittelbar in dem Bereich angeordnet, in dem eine besonders große Wärmeentwicklung zu rechnen ist. An der Unterseite der Hochfrequenzplatine 1 ist ein weiterer HF-Verstärker 5 vorgesehen, der hier auf die Unterseite 2 der Platine direkt aufgelötet ist. Das Vorsehen einer weiteren Ausnehmung in der Unterseite 3 ist vorliegend nicht notwendig, da die Wärmeentwicklung an der Unterseite 3 aufgrund der Ausgestaltung des HF-Verstärkers geringer ist.

In dem Ausführungsbeispiel sind die Mikrokühlkörper 6 aus Nickel gebildet. In einem weiteren nicht dargestellten Ausführungsbeispiel ist der Mikrokühlkörper 6 aus Kupfer, Aluminium, Zinn oder Weißbronze gebildet.

Beabstandet von dem Bereich der Hochfrequenzplatine 1, in der der HF-Verstärker 5 vorgesehen ist, weist der Kühlabschnitt 4 ein Material auf, was eine sehr geringe Wärmeleitfähigkeit aufweist und elektrisch nicht leitend ist. In dem hier gezeigten Ausführungsbeispiel ist dieser Bereich aus faserverstärktem Kunststoff auf Epoxybasis 7 gebildet. Gerade in den Bereichen elektrisch nicht leitendem Materials ist ein Durchkontaktieren der Platine1 über Vias 8 auf besonders einfache Weise möglich.

Wie dem Ausführungsbeispiel zu entnehmen ist, wird durch Vorsehen eines Kühlabschnittes 4 mit einem Mikrokühlkörper 6 in Bereichen großer Wärmeentwicklung wie beispielsweise bei Anordnung aktiver Schaltungen 5 an der HF-Platine1 und mindestens einem weiteren Material in Bereichen geringerer Wärmeentwicklung, hier in der Form eines glasfaserverstärkten Kunststoffes auf Epoxybasis 7, eine sogenannte modulare Kühlung erreicht.

Vorteil eines solchen modularen Aufbaus des Kühlabschnittes 4 ist neben der damit einhergehenden Gewichtsreduktion - glasfaserverstärkter Kunststoff ist wesentlich leichter als ein vollständiger Kupferkern - auch eine deutliche Reduktion der Abmessungen. So ist es möglich, den Kühlabschnitt 4 im Vergleich zu dem sonst im Stand der Technik bekannten Kupferkern deutlich kleiner auszugestalten.

## Patentansprüche

1. Leiterplatte, insbesondere eine Hochfrequenzplatine (1), die einen Kühlabschnitt (4) mit mindestens einem Mikrokühlkörper (6) aufweist, über den sich an der Hochfrequenzplatine (1) entwickelnde Wärme abführbar ist, **dadurch gekennzeichnet, dass** der Kühlabschnitt (4) so ausgebildet ist, dass der Mikrokühlkörper (6) in Bereichen großer Wärmeentwicklung, insbesondere unmittelbar unterhalb von an der Hochfrequenzplatine (1) angebrachten aktiven Schaltungen, angeordnet ist, und in Bereichen geringer Wärmeentwicklung ein Material mit geringerer Wärmeleitfähigkeit aufweist.

2. Leiterplatte nach Anspruch 1, **dadurch gekennzeichnet, dass** der Mikrokühlkörper (6) aus Kupfer, Aluminium, Zinn, Nickel oder Weißbronze gebildet ist.

3. Leiterplatte nach Anspruch 1 oder 2, **dadurch gekennzeichnet, dass** das Material mit kleiner oder geringer Wärmeleitfähigkeit aus keramik-gefülltem Kunststoff, PTFE oder glasfaserverstärktem Kunststoff auf Epoxybasis gebildet sind.

4. Leiterplatte nach einem der Ansprüche 1 bis 3, **dadurch gekennzeichnet, dass** dem Mikrokühlkörper (6) ein Kühlmedium zuführbar und aus ihm abführbar ist, wobei das Kühlmedium eine Temperatur zwischen 10° C und 28° C, bevorzugt zwischen 15° C und 25° C, bevorzugt zwischen 20° C und 24° C aufweist.

5. Leiterplatte nach einem der vorhergehenden Ansprüche, **dadurch gekennzeichnet, dass** der Kühlabschnitt (4) mindestens zwei Mikrokühlkörper (6) aufweist, wobei einem der Mikrokühlkörper (6) ein Kühlmedium mit konstanter Temperatur zugeführt oder zuführbar ist und einem weiteren Mikrokühlkörper (6) ein Kühlmedium zuführbar ist, dessen Temperatur in Abhängigkeit einer an der Leiterplatte gemessenen Temperatur einstellbar ist.

6. Leiterplatte nach einem der vorhergehenden Ansprüche, **dadurch gekennzeichnet, dass** der Mikrokühlkörper (6) eine monolithische Struktur aufweist und insbesondere mittels des selektiven Lasersinterns gebildet ist.

7. Leiterplatte nach einem der vorhergehenden Ansprüche, **dadurch gekennzeichnet, dass** eine Oberseite und/oder eine Unterseite der Leiterplatte mit dem Kühlabschnitt (4) verklebt, verpresst, verlötet oder verschraubt ist.

8. Leiterplatte nach einem der vorhergehenden Ansprüche, **dadurch gekennzeichnet, dass** eine Außenfläche des Kühlabschnittes (4) eine zumindest abschnittsweise koplanare Oberfläche aufweist.

9. Leiterplatte nach einem der vorhergehenden Ansprüche, **dadurch gekennzeichnet, dass** mindestens eine Außenfläche des Mikrokühlkörpers (6) eben zu der Hochfrequenzplatine (1) ausgebildet ist, so dass die Oberseite und/oder die Unterseite der Hochfrequenzplatine (1) plan an der Außenfläche des Kühlabschnittes (4) anbringbar ist.

10. Elektronikbauteil mit mindestens einem Halbleiterbauelement nach einem der Ansprüche 1 bis 9.
